# EUROPEAN PATENT APPLICATION

(11) **EP 4 749 884 A1**
(43) Date of publication of application: **27.05.2026**
(21) Application number: 25218164.9
(22) Date of filing: 24.11.2025
(51) Int. Cl.: H02J 7/70, H02J 7/96, H02J 9/06

(54) **SYSTEM FOR POWERING UNINTERRUPTIBLE POWER SUPPLY (UPS) USING EXTERNAL BATTERY CABINET (EBC)**

(30) Priority: 26.11.2024 IN 202421092268; 17.11.2025 US 202519391794
(71) Applicant: Vertiv Corporation, Westerville, OH 43082 (US)
(72) Inventor: RICCA, Steven V., Westerville 43082 (US); NIDGUNDI, Vijay, Westerville 43082 (US); GAIKWAD, Dipak, Westerville 43082 (US); BODAKE, Vijay, Westerville 43082 (US)
(74) Representative: Bryn-Jacobsen, Caelia

(57) **Abstract**

A system may include an external battery cabinet (EBC) configured to power an uninterruptible power supply (UPS), where the EBC operates at a predetermined battery voltage. The system may include a boost pulse-width modulator (PWM) controller including two or more operating switches and a boost converter coupled to the boost PWM controller, where the boost converter is configured to increase the predetermined battery voltage. The system may include a bypass circuit to allow power to directly flow from the EBC to the UPS. The system may include a voltage sensing circuit configured to measure a voltage of the EBC and the UPS. The system may include a microcontroller configured to generate one of one or more boost signals or one or more bypass signals to activate one of the boost converter or the bypass circuit based on the voltage of the EBC and the UPS.

## Description

### CROSS-REFERENCE TO RELATED APPLICATIONSFIELD

The present application claims the benefit of India Provisional Application No. 202421092268, filed November 26, 2024.

### TECHNICAL FIELD

The present disclosure relates to the field of power management systems, and more particularly to, a system and method for powering an uninterruptible power supply (UPS) using an external battery cabinet (EBC).

### BACKGROUND

Power failures are a fact of life, uninterruptable power supplies (UPS) help keep data centers running even when there is a tripped breaker or larger outage. However, UPS solutions have not evolved much in the past few years. As such, data centers are searching for ways to reduce the size and weight of these systems, reduce cooling requirements, and extend the life of UPS systems.

Conventional UPS systems utilize lithium-ion batteries to provide power in case of an outage. However, lithium-ion batteries have a number of disadvantages. For example, lithium-ion batteries are expensive and have thermal sensitivity. Further, lithium-ion batteries also have a higher risk of overheating and catching fire if they are not handled properly or exposed to extreme temperatures. Therefore, lithium-ion batteries need careful battery management and protection systems to ensure their safety and performance. The higher cost can also be a barrier to their adoption within large-scale UPS systems, where cost-effectiveness is crucial.

Additionally, it is important to ensure that the battery voltage of the EBC matches the battery voltage of the UPS. For example, connecting an EBC with a different battery voltage to the UPS can cause damage to the equipment or may cause the system to malfunction. In a non-limiting example, a 36V UPS can only work with a 36V EBC, otherwise, the system may malfunction or cause damage to the equipment.

As such, there is a need for a system for powering uninterruptible power supply (UPS) using an external battery cabinet (EBC) which addresses one or more of the above identified shortfalls of the previous approaches.

### SUMMARY

Some of the objects of the present disclosure, which at least one example herein satisfies, are as follows:
In examples, a system for powering an uninterruptible power supply including: an external battery cabinet configured to power the uninterruptible power supply, wherein the external battery cabinet operates at a predetermined battery voltage; a boost pulse-width modulator (PWM) controller including two or more operating switches; a boost converter coupled to the boost PWM controller, wherein the boost converter is configured to increase the predetermined battery voltage of the external battery cabinet based on signals received from the two or more operating switches; a bypass circuit configured to bypass the boost converter to allow power to directly flow from the external battery cabinet to the uninterruptible power supply without increasing the predetermined battery voltage of the external battery cabinet; a voltage sensing circuit configured to measure a voltage of the external battery cabinet and the uninterruptible power supply; and a microcontroller configured to generate at least one of one or more boost signals or one or more bypass signals to activate at least one of the boost converter or the bypass circuit based on the voltage measured by the voltage sensing circuit of the external battery cabinet and the uninterruptible power supply.

In examples, a method for powering an uninterruptible power supply including: receiving a battery status input from an external battery cabinet; receiving a power supply status input from the uninterruptible power supply; comparing the battery status input and the power supply; upon determining the battery status input is less than the power supply status input, generating one or more boost signals to cause a boost converter to increase a battery voltage of the external battery cabinet to power the uninterruptible power supply; upon determining the battery status input is equal to the power supply status input, generating one or more bypass signals to cause a bypass circuit to bypass the boost converter to directly power the uninterruptible power supply.

Other objects and advantages of the present disclosure will be more apparent from the following description, which is not intended to limit the scope of the present disclosure.

### BRIEF DESCRIPTION OF THE DRAWINGS

A system for powering an uninterruptible power supply (UPS) using an external battery cabinet (EBC) of the present disclosure will now be described with the help of the accompanying drawing, in which:
FIG. 1A illustrates a simplified block diagram of a system for powering an uninterruptible power supply (UPS) using an external battery cabinet (EBC), in accordance with the one or more examples of the present disclosure.
FIG. 1B illustrates a perspective view of the UPS and EBC, in accordance with one or more examples of the present disclosure.
FIG. 2A illustrates a flowchart of a method of operating the system in different modes, in accordance with one or more examples of the present disclosure.
FIG. 2B illustrates a flowchart of a method of powering the UPS using the EBC, in accordance with one or more examples of the present disclosure.
FIG. 3 illustrates a graph depicting the Voltage vs efficiency of the system, in accordance with one or more examples of the present disclosure.

### DETAILED DESCRIPTION

Examples are provided so as to thoroughly and fully convey the scope of the present disclosure to the person skilled in the art. Numerous details are set forth relating to specific components, and methods, to provide a complete understanding of examples of the present disclosure. It will be apparent to the person skilled in the art that the details provided in the examples should not be construed to limit the scope of the present disclosure. In some examples, well-known processes, well-known apparatus structures, and well-known techniques are not described in detail.

The terminology used, in the present disclosure, is only for the purpose of explaining a particular example and such terminology shall not be considered to limit the scope of the present disclosure. As used in the present disclosure, the forms "a," "an," and "the" may be intended to include the plural forms as well, unless the context clearly suggests otherwise. The terms "comprises," "comprising," "including," and "having," are open-ended transitional phrases and therefore specify the presence of stated features, elements, modules, units and/or components, but do not forbid the presence or addition of one or more other features, elements, components, and/or groups thereof.

Examples of the present disclosure are directed towards a system and method for powering uninterruptible power supply (UPS) using an external battery cabinet (EBC). For example, the EBC of the system may be compatible with UPS systems that have different battery inputs. In this regard, customers may save costs by using the same EBC for different UPS models. Further, the EBC of the system may provide reliable and efficient backup power for critical applications/infrastructure.

It is contemplated herein that the system and method of the present disclosure may have several technical advantages over previous systems/methods. For example, the system and method of the present disclosure may provide a larger backup time for uninterruptible power supply (UPS) and extend the runtime of the UPS system. By way of another example, the system and method of the present disclosure may be cost-efficient and provide reliable and continuous backup power for data centers.

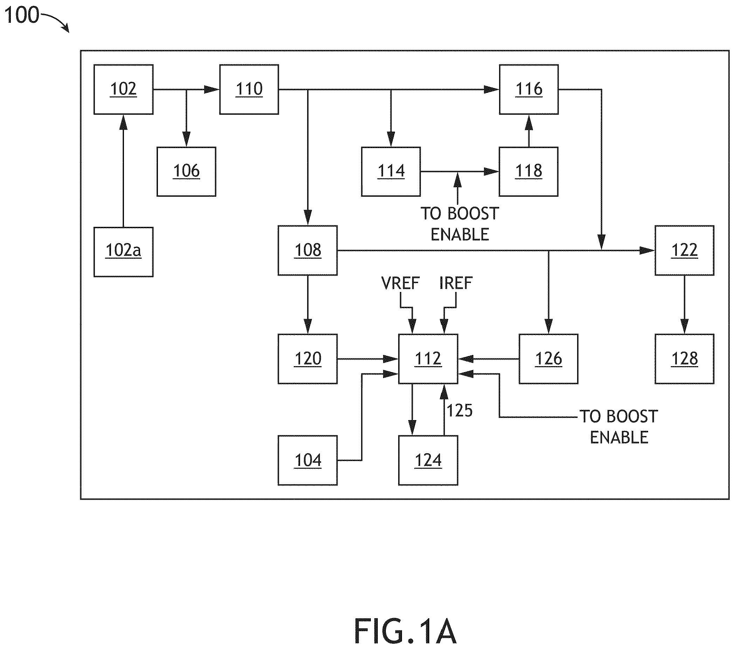

Examples of the present disclosure will now be described with reference to the accompanying drawing, which will now be described in detail with reference to FIGS. 1A-3.

FIG. 1A illustrates a simplified block diagram of a system 100 for powering an uninterruptible power supply (UPS) using an external battery cabinet (EBC), in accordance with the one or more examples of the present disclosure.

The system 100 includes, but is not limited to, an external battery cabinet (EBC) 102, an auxiliary power supply unit 106, an over current protection device 110, a boost pulse-width modulator (PWM) controller module 112, a voltage sensing circuit 114, a microcontroller 124, and an uninterruptible power supply (UPS) 128.

In examples, the EBC 102 includes a sodium ion (Na-ion) external battery cabinet. For example, the Na-ion EBC 102 may utilize sodium ions (Na⁺).

The EBC 102 may be configured to operate at different voltage levels. For example, in a non-limiting example, the EBC 102 may operate at 36V. By way of another example, in a non-limiting example, the EBC 102 may operate at 48V. By way of another example, in a non-limiting example, the EBC 102 may operate at 72V.

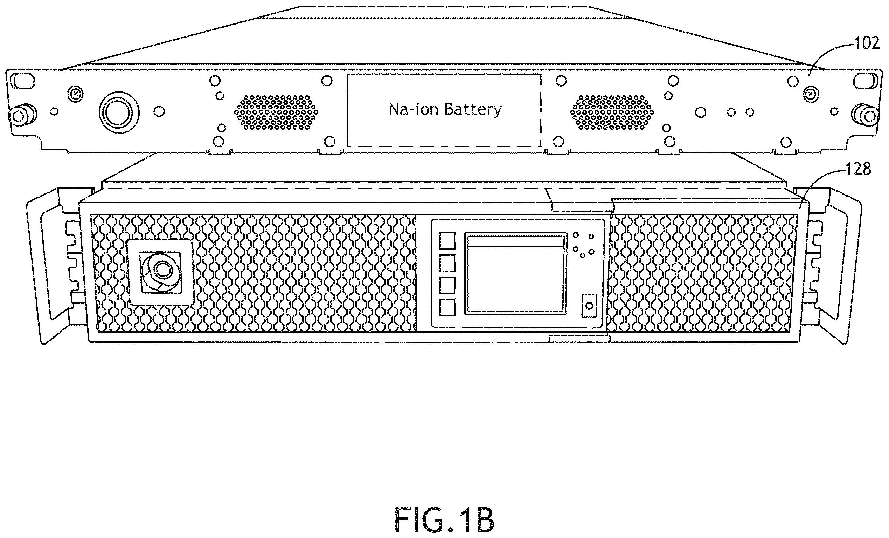

FIG. 1B illustrates a perspective view of the EBC coupled to the UPS 128. The EBC 102 may be configured to serve as an independent external power source designed to supply stable DC voltage to the UPS 128 during primary power interruptions or voltage fluctuations. The EBC 102 may be housed in a compact rack-mountable enclosure and incorporates the Na-ion battery pack, which provides superior energy density, thermal stability, and long cycle life compared to conventional lead-acid or lithium-ion batteries.

In the illustrated example, the EBC 102 may be physically and electrically coupled to the UPS 128 via a dedicated connector interface that enables seamless power transfer and communication between the two units. The Na-ion battery pack within the EBC 102 may be configured to operate over multiple discrete voltage levels such as 36V, 48V, and 72V depending on the UPS configuration. The connection enables the system 100 to dynamically adjust voltage levels as governed by the internal control circuitry described in FIG. 1A.

The Na-ion chemistry of the EBC 102 allows the system 100 to deliver reliable backup power with improved thermal safety and reduced cost, while maintaining compatibility with multiple UPS input voltage requirements. The UPS 128 shown in FIG. 1B represents a standard rack-mountable UPS unit that receives conditioned DC input from the EBC 102 and converts it to AC power for downstream equipment. Together, the EBC 102 and the UPS 128 from an integrated, adaptable, and high-efficiency power backup system 100 suitable for data centers, industrial environments, and mission-critical applications.

The EBC 102 may be configured to couple to a battery charger 102a. For example, the battery charger 102a may ensure that the EBC 102 is kept at sufficient charge levels and may provide power to the EBC 102 whenever required.

In examples, the EBC 102 may be configured to couple to the auxiliary power supply unit 106. For example, the auxiliary power supply unit 106 may be configured to be in connection with the EBC 102 to provide a predetermined amount of power (e.g., 12V direct-current (DC)) to power other circuits within the system 100.

The over current protection device 110 may be connected to the EBC 102 to protect the system 100 from overcurrent. For example, the over current protection device 110 may include a fuse configured to protect the system 100 from overcurrent. For instance, the EBC 102 may be configured to deliver output power to the auxiliary power supply unit 106, which may channel current through the over-current protection device 110 to safeguard the downstream components from excessive current flow.

The voltage sensing circuit 114 may be configured to monitor voltage levels of the EBC 102 and the UPS 128. For example, the voltage sensing circuit 114 may be configured to connect to the microcontroller 124 to monitor the voltage levels of both the EBC 102 and the UPS 128.

In examples, the system 100 further includes a power supply 104. For example, the boost PWM controller module 112 may be connected to a direct-current (DC) power supply 104. For instance, the DC power supply 104 may be configured to provide 12V DC power to the boost PWM controller module 112.

The boost PWM controller module 112 may include a boost converter 108, a driver circuit 120, a bypass circuit 116, and a bypass controller 118. The EBC 102 may be configured to regulate the boost converter 108 and/or the bypass circuit 116. For example, in parallel, the bypass circuit 116 may be connected to form a direct electrical path from the EBC 102 to the UPS 128 when the input battery voltage substantially matches the required UPS input voltage, as will be discussed further herein.

The boost PWM controller module 112 may be configured to maintain a stable output voltage from the boost converter 108. The boost converter 108 may be further configured to step up (or increase) the input battery voltage required for the uninterruptible power supply (UPS) operation when the input battery voltage is low.

In examples, the boost converter 108 is controlled by the boost PWM controller module 112. For example, the microcontroller 124 may be configured to generate one or more signals 125 to at least one of activate or deactivate the boost converter 108. For instance, when the boost circuit is enabled (or activated), the boost converter 108 may be configured to increase the input battery voltage required for the UPS output. For example, in a non-limiting example, where the EBC 102 voltage is 36V, the boost converter 108 may be configured to increase the voltage to approximately 53V. By way of another example, in a non-limiting example, where the EBC 102 voltage is 48V, the boost converter 108 may be configured to increase the voltage to approximately 75V.

The system 100 further includes a driver circuit 120. For example, the driver circuit 120 may be connected to the boost converter 108, where the driver circuit 120 may be configured to provide an input supply voltage to the boost PWM controller module 112 to generate driving pulses for two or more operating switches. For instance, the driver circuit 120 may include a field-effect transistor (e.g., metal oxide semiconductor field-effect transistor (MOSFET)) driver circuit configured to provide an input supply voltage to the boost PWM controller module 112 to generate driving pulses for the operating switches. In this regard, the driver circuit 120 may be configured amplify the control signals to ensure proper timing and sequence between the two or more switching units, thereby enabling either the boost converter 108 or the bypass circuit 116 at any given time.

The operating switches may include at least a first switching unit (Sw1) and a second switching unit (*Sw*₂) in a predetermined sequence. For example, the first switching unit (Sw1) may be operatively connected to the boost converter 108 to control the activation of a switching path within the boost converter 108, while the second switching unit (Sw2) may be operatively connected to the bypass circuit 116 to control conduction of the bypass path. Each of the operating switches *Sw1,* Sw2 may include, but are not limited to, a source terminal, a gate terminal, and a drain terminal.

In examples, a voltage probe and a current probe may be used to measure the input voltage and current values and their waveforms.

The boost PWM controller module 112 may be further configured for interfacing with the EBC 102 and an inverter of the microcontroller 124. For example, the inverter may be configured to convert DC power to AC power.

In examples, the microcontroller 124 is configured to generate a control signal in a predetermined timing sequence to trigger the first switching unit *S_{w1}* and the second switching unit Sw2. For example, the microcontroller 124 may be configured to adjust the inverter stage input voltage by controlling the battery boost output voltage. When the battery voltage of the EBC 102 is within a predetermined range, the microcontroller 124 may be configured to send a signal to the bypass circuit 116. When the battery output voltage of the EBC 102 drops, the microcontroller 124 may be configured to generate signals to changeover to the boost mode to keep the inverter input in the optimal range. The microcontroller 124 may be further configured to measure the EBC 102 output voltage, UPS battery information, and all other parameters.

The bypass circuit 116 may be configured to allow power to directly flow from the EBC 102 to the UPS 128 without any voltage conversion. For example, the bypass controller 118 may be configured to switch to bypass mode based on the input signal received from the voltage sensing circuit 114 and commands (or signals) from the microcontroller 124. In this regard, when in the Bypass and Boost mode, a 36V Na-ion battery may be connected to 36V, 48V, and 72V UPS inverter stages. Similarly, a 48V Na- ion battery may be connected to the 48V and 72V UPS inverter stage. As such, this ensures efficient backup power for the data centers, etc.

Exemplary output voltages from the EBC 102 modes of operation, and the input requirements for the UPS 128, are shown below in Table 1:

**TABLE 1**

| **Na-ion Battery** | **Mode** | **O/P of EBC** | **I/P Requirement of UPS** |
|---|---|---|---|
| 36V | Bypass | 36V | 36V |
| | Boost | 54V | 48V |
| | Boost | 75V | 72V |
| 48V | Bypass | 48V | 48V |
| | Boost | 75V | 72V |
| 72V | Bypass | 72V | 72V |

Before delivering power to the UPS 128, the system 100 further includes a reverse voltage protection unit 122. The reverse voltage protection unit 122 may ensure that power is only allowed to flow in the correct direction to prevent damage to the UPS 128 or EBC 102 in case of accidental reverse polarity connections. For example, the regulated power may be delivered to the UPS 128, where the UPS 128 may be configured to provide continuous power to connected loads. In this regard, the UPS 128 ensures uninterrupted operation of critical systems during power outages or fluctuations by switching to battery power seamlessly.

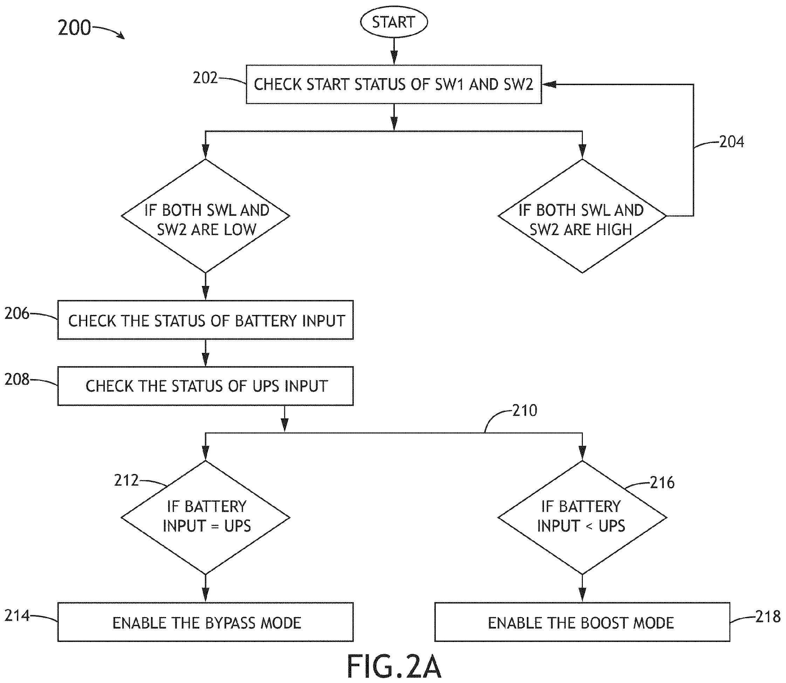

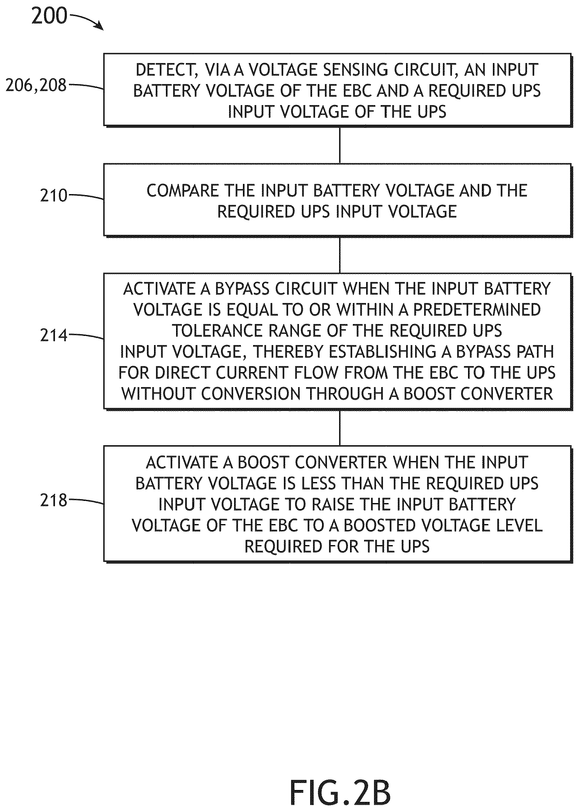

FIGS. 2A-2B illustrate flowcharts of a method 200 of operating the system 100 in different modes (e.g., bypass mode or boost mode) based on the comparison of external battery input voltage and UPS input voltages, in accordance with one or more examples of the present disclosure.

In a step 202, the method 200 may include checking a status of the operating switches *Sw1, Sw2.* For example, the microcontroller 124 may be configured to generate a control signal in a predetermined timing sequence to trigger the first switching unit *S_{w1}* and the second switching unit *Sw2,* where the respective switches correspond to the switching paths of the boost converter 108 and the bypass circuit 116, respectively. In examples, each of the first switching unit *S_{w1}* and the second switching unit *Sw2* may include a bridge circuit configuration.

In examples, the control signals generated by the microcontroller 124 may be based on the external battery input voltages and the UPS input voltages from the EBC 102 and the UPS 128, respectively.

If the statuses of both the first switching unit *S_{w1}* and the second switching unit *Sw2* are high, in a step 204, the method 200 may include returning to step 202 to check the status of the operating switches *Sw1, Sw2* again.

If the statuses of both the first switching unit *S_{w1}* and the second switching unit *Sw2* are low, in a step 206, the method 200 may include checking the battery input voltage. Further, in a step 208, the method 200 may include checking the UPS input voltage.

In a step 210, the method 200 may include comparing the battery input voltage (from step 206) with the input voltage of the UPS 128 (from step 208).

For example, in a step 212, the battery input may be equal to the UPS input. Upon determining the battery input is equal to the UPS input, in a step 214, bypass mode may be enabled. For instance, the microcontroller 124 may be configured to enable bypass mode and allows the battery to directly power the UPS without any voltage boosting.

By way of another example, in a step 216, the battery input may be less than the UPS input. Upon determining the battery input is less than the UPS input, in a step 218, boost mode may be enabled. For example, the microcontroller 124 may be configured to enable boost mode which activates the boost converter 108 to step up the battery voltage to be required for the UPS. This ensures that the operating voltage of the UPS is the same even when the battery voltage is lower. The microcontroller 124 continuously monitors the status of the switching units Sw1 and *Sw2.*

Upon determining the battery status input is greater than the UPS input, the microcontroller 124 may be configured to generate the one or more bypass signals to cause the bypass circuit 116 to bypass the boost converter 118 to directly power the UPS 128.

In an exemplary example, in bypass mode, if the output requires 48V and the input is connected to a 48V Na-ion battery, the bypass mode may be enabled. In an additional exemplary example, in bypass mode, if the output requires 48V and the input is connected to a 36V Na-ion battery, the bypass mode may be enabled. In an additional exemplary example, in bypass mode, if the output requires 48V and the input is connected to a 72V Na-ion battery, the bypass mode may be enabled. In this regard, bypass mode may be configured to increase the efficiency of the system 100 while reducing heat dissipation.

In boost mode, the output voltage may be increased and kept in an optimal range for the UPS inverter stage. For example, the boost mode may increase the battery voltage to 75V DC over the entire battery range, regardless of output voltage.

It is contemplated herein that there many combinations of input and outputs are possible depending on the battery configuration and desired boost output range, as such the discussion herein shall not be construed as limiting the scope of the present disclosure. For example, in a non-limiting example, a 36V Na-ion external battery cabinet (EBC) may be connected to 36V, 48V, and 72V UPS. By way of another example, in a non-limiting example, a 48V Na-ion external battery cabinet (EBC) may be connected to 48V and 72V UPS. By way of another example, in a non-limiting example, a 72V Na-ion external battery cabinet (EBC) may be connected to 72V UPS only.

Further, the decision-making logic outlined in FIGS. 2A-2B enables autonomous operation of the system 100, ensuring that the UPS 128 receives a constant and reliable input voltage irrespective of variations in the voltage level of the EBC 102. The closed-loop control 126 between the microcontroller 124, the voltage sensing circuit 114, the boost converter 108, and the bypass circuit 116 ensures seamless switching between modes, thereby maintaining continuous power delivery, improving energy efficiency, and preventing power interruptions to connected loads.

Thus, the system 100 and method 200 overcomes the limitations of conventional uninterruptible power supply (UPS) systems that rely on fixed-voltage lithium-ion or lead-acid external battery cabinets by introducing an adaptive and intelligent sodium-ion (Na-ion) based external battery cabinet (EBC) capable of operating across multiple discrete voltage levels. The disclosed system and method dynamically compare the input battery voltage and required UPS input voltage using the microcontroller 124 and automatically switch between boost mode and bypass mode, ensuring seamless voltage compatibility and uninterrupted power delivery. By integrating a boost converter 108 and a bypass circuit 116 under real-time control, the system minimizes conversion losses, enhances efficiency, and prevents equipment damage due to voltage mismatch. This intelligent voltage adaptation capability, combined with the thermal stability and cost advantages of Na-ion chemistry, enables a highly reliable, efficient, and safe UPS power backup architecture suitable for modern data centers and mission-critical applications.

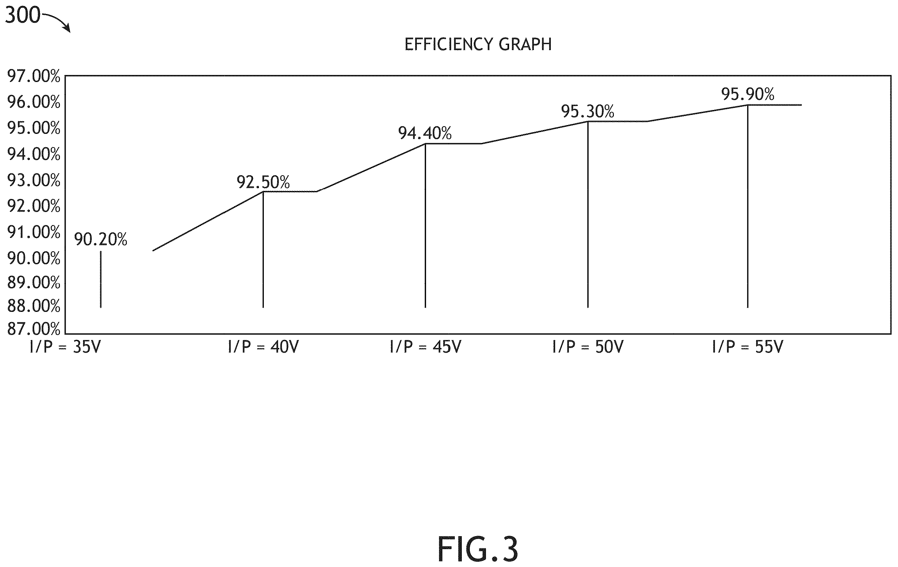

FIG. 3 illustrates the graph 300 depicting the Voltage vs efficiency of the system, in accordance with one or more examples of the present disclosure.

For example, as shown in the graph 300, as the voltage delivered from the battery system to the UPS inverter stage increases, the overall system efficiency also increases. This is due to a UPS inverter being a constant power delivery device. So, for the same amount of delivered power, as voltage increases, the amperes delivered decrease.

As shown in the efficiency graph 300, when the input voltage is approximately 35V, the system 100 may be around 90.2%. As the input voltage increases to 40V, the efficiency improves to 92.5%, and further increases to 94.4% at 45V. The efficiency continues to rise, reaching 95.3% at 50V, and peals at approximately 95.9% when the input voltage is 55V. This trend demonstrates that the system efficiency improves as the input voltage from the EBC 102 approaches the optimal operational range of the UPS 128.

The foregoing description of the examples has been provided for purposes of illustration and is not intended to limit the scope of the present disclosure. Individual components of a particular example are generally not limited to that particular example, but, are interchangeable. Such variations are not to be regarded as a departure from the present disclosure, and all such modifications are considered to be within the scope of the present disclosure.

The present disclosure described herein above has several technical advantages including, but not limited to, providing larger backup time for uninterruptible power supply (UPS), being cost-efficient, working with UPS systems having 36V, 48V or 72V battery input, and providing reliable and efficient backup power for data centers.

The examples herein and the various features and advantageous details thereof are explained with reference to the non-limiting examples in the following description.

Descriptions of well-known components and processing techniques are omitted so as to not unnecessarily obscure the examples herein. The examples used herein are intended merely to facilitate an understanding of ways in which the examples herein may be practiced and to further enable those of skill in the art to practice the examples herein. Accordingly, the examples should not be construed as limiting the scope of the examples herein.

The foregoing description of the specific examples so fully reveal the general nature of the examples herein that others can, by applying current knowledge, readily modify and/or adapt for various applications such specific examples without departing from the generic concept, and, therefore, such adaptations and modifications should and are intended to be comprehended within the meaning and range of equivalents of the disclosed examples. It is to be understood that the phraseology or terminology employed herein is for the purpose of description and not of limitation. Therefore, while the examples herein have been described in terms of preferred examples, those skilled in the art will recognize that the examples herein can be practiced with modification within the scope of the examples as described herein.

The use of the expression "at least" or "at least one" suggests the use of one or more elements or ingredients or quantities, as the use may be in the example of the disclosure to achieve one or more of the desired objects or results.

Any discussion of devices, articles or the like that has been included in this specification is solely for the purpose of providing a context for the disclosure. It is not to be taken as an admission that any or all of these matters form a part of the prior art base or were common general knowledge in the field relevant to the disclosure as it existed anywhere before the priority date of this application.

Further examples are set out in the clauses below:
1. A system for powering an uninterruptible power supply comprising:
   an external battery cabinet configured to power the uninterruptible power supply, wherein the external battery cabinet operates at a predetermined battery voltage;
   a boost pulse-width modulator (PWM) controller including two or more operating switches;
   a boost converter coupled to the boost PWM controller, wherein the boost converter is configured to increase the predetermined battery voltage of the external battery cabinet based on signals received from the two or more operating switches;
   a bypass circuit configured to bypass the boost converter to allow power to directly flow from the external battery cabinet to the uninterruptible power supply without increasing the predetermined battery voltage of the external battery cabinet;
   a voltage sensing circuit configured to measure a voltage of the external battery cabinet and the uninterruptible power supply; and
   a microcontroller configured to generate at least one of one or more boost signals or one or more bypass signals to activate at least one of the boost converter or the bypass circuit based on the voltage measured by the voltage sensing circuit of the external battery cabinet and the uninterruptible power supply.
2. The system of clause 1, further comprising:
   a driver circuit configured to power an input supply voltage to the boost PWM controller to generate one or more driving pulses for the two or more operating switches.
3. The system of clause 2, wherein the driver circuit comprises a metal oxide semiconductor field-effect transistor.
4. The system of any one of the preceding clauses, further comprising:
   an auxiliary power supply unit configured to couple to the external battery cabinet to provide a predetermined amount of power to the external battery cabinet.
5. The system of any one of the preceding clauses, further comprising:
   a direct-current power supply configured to couple to the boost PWM controller to provide direct-current power to the boost PWM controller.
6. The system of any one of the preceding clauses, further comprising:
   a reverse voltage protection unit coupled to the uninterruptible power supply, wherein the reverse voltage protection unit is configured to regulate power delivered to the uninterruptible power supply and monitor direction of the power to prevent damage to the uninterruptible power supply.
7. The system of any one of the preceding clauses, further comprising:
   one or more over current protection devices configured to couple to the external battery cabinet, wherein the one or more over current protection devices are configured to protect the system from overcurrent.
8. The system of any one of the preceding clauses, wherein the predetermined battery voltage of the external battery cabinet is 36V.
9. The system of clause 8, wherein the uninterruptible power supply operates at one of 48V or 72V.
10. The system of clause 8, wherein the boost converter is configured to increase the predetermined voltage to greater than 48V.
11. The system of clause 8, wherein the uninterruptible power supply operates at 36V, wherein the bypass circuit is configured to cause the external battery cabinet to directly power the uninterruptible power supply and bypass the boost converter.
12. The system of any one of the preceding clauses, wherein the predetermined battery voltage of the external battery cabinet is 48V.
13. The system of clause 12, wherein the uninterruptible power supply operates at 72V.
14. The system of clause 12, wherein the boost converter is configured to increase the predetermined voltage to greater than 72V.
15. The system of clause 12, wherein the uninterruptible power supply operates at 72V.
16. The system of clause 8, wherein the uninterruptible power supply operates at 48V, wherein the bypass circuit is configured to cause the external battery cabinet to directly power the uninterruptible power supply and bypass the boost converter.
17. A method for powering an uninterruptible power supply comprising:
   receiving a battery status input from an external battery cabinet;
   receiving a power supply status input from the uninterruptible power supply;
   comparing the battery status input and the power supply status input;
   upon determining the battery status input is less than the power supply status input, generating one or more boost signals to cause a boost converter to increase a battery voltage of the external battery cabinet to power the uninterruptible power supply; and
   upon determining the battery status input is equal to the power supply status input, generating one or more bypass signals to cause a bypass circuit to bypass the boost converter to directly power the uninterruptible power supply.
18. The method of clause 17, further comprising:
   monitoring a direction of the power to the uninterruptible power supply to prevent damage to the uninterruptible power supply.
19. The method of clause 17 or 18, further comprising:
   upon determining the battery status input is greater than the uninterruptible power supply, generating the one or more bypass signals to cause the bypass circuit to bypass the boost converter to directly power the uninterruptible power supply.
20. The method of any one of clauses17-19, further comprising:
   receiving a switch status for each switch of two or more operating switches;
   upon determining a first switch status and a second switch status are below a predetermined threshold, receiving the battery status input from the external battery cabinet; and
   upon determining the first switch status and the second switch status are greater than the predetermined threshold, receiving an additional switch status for each switch of the two or more operating switches.

While considerable emphasis has been placed herein on the components and component parts of the preferred examples, it will be appreciated that many examples can be made and that many changes can be made in the preferred examples without departing from the principles of the disclosure. These and other changes in the preferred example as well as other examples of the disclosure will be apparent to those skilled in the art from the disclosure herein, whereby it is to be distinctly understood that the foregoing descriptive matter is to be interpreted merely as illustrative of the disclosure and not as a limitation.

## Claims

1. A system for powering an uninterruptible power supply comprising:
an external battery cabinet configured to power the uninterruptible power supply, wherein the external battery cabinet operates at a predetermined battery voltage;
a boost pulse-width modulator (PWM) controller including two or more operating switches;
a boost converter coupled to the boost PWM controller, wherein the boost converter is configured to increase the predetermined battery voltage of the external battery cabinet based on signals received from the two or more operating switches;
a bypass circuit configured to bypass the boost converter to allow power to directly flow from the external battery cabinet to the uninterruptible power supply without increasing the predetermined battery voltage of the external battery cabinet;
a voltage sensing circuit configured to measure a voltage of the external battery cabinet and the uninterruptible power supply; and
a microcontroller configured to generate at least one of one or more boost signals or one or more bypass signals to activate at least one of the boost converter or the bypass circuit based on the voltage measured by the voltage sensing circuit of the external battery cabinet and the uninterruptible power supply.

2. The system of claim 1, further comprising:
a driver circuit configured to power an input supply voltage to the boost PWM controller to generate one or more driving pulses for the two or more operating switches.

3. The system of claim 2, wherein the driver circuit comprises a metal oxide semiconductor field-effect transistor.

4. The system of any one of the preceding claims, further comprising:
an auxiliary power supply unit configured to couple to the external battery cabinet to provide a predetermined amount of power to the external battery cabinet.

5. The system of any one of the preceding claims, further comprising:
a direct-current power supply configured to couple to the boost PWM controller to provide direct-current power to the boost PWM controller.

6. The system of any one of the preceding claims, further comprising:
a reverse voltage protection unit coupled to the uninterruptible power supply, wherein the reverse voltage protection unit is configured to regulate power delivered to the uninterruptible power supply and monitor direction of the power to prevent damage to the uninterruptible power supply.

7. The system of any one of the preceding claims, further comprising:
one or more over current protection devices configured to couple to the external battery cabinet, wherein the one or more over current protection devices are configured to protect the system from overcurrent.

8. The system of any one of the preceding claims, wherein the predetermined battery voltage of the external battery cabinet is 36V.

9. The system of claim 8, wherein the uninterruptible power supply operates at one of 48V or 72V; or optionally
wherein the boost converter is configured to increase the predetermined voltage to greater than 48V; or optionally
wherein the uninterruptible power supply operates at 36V, wherein the bypass circuit is configured to cause the external battery cabinet to directly power the uninterruptible power supply and bypass the boost converter.

10. The system of any one of the preceding claims, wherein the predetermined battery voltage of the external battery cabinet is 48V.

11. The system of claim 10, wherein the uninterruptible power supply operates at 72V.

12. The system of claim 10, wherein the boost converter is configured to increase the predetermined voltage to greater than 72V.

13. The system of claim 8, wherein the uninterruptible power supply operates at 48V, wherein the bypass circuit is configured to cause the external battery cabinet to directly power the uninterruptible power supply and bypass the boost converter.

14. A method for powering an uninterruptible power supply comprising:
receiving a battery status input from an external battery cabinet;
receiving a power supply status input from the uninterruptible power supply;
comparing the battery status input and the power supply status input;
upon determining the battery status input is less than the power supply status input, generating one or more boost signals to cause a boost converter to increase a battery voltage of the external battery cabinet to power the uninterruptible power supply; and
upon determining the battery status input is equal to the power supply status input, generating one or more bypass signals to cause a bypass circuit to bypass the boost converter to directly power the uninterruptible power supply.

15. The method of claim 14, further comprising:
monitoring a direction of the power to the uninterruptible power supply to prevent damage to the uninterruptible power supply; or optionally further comprising:
upon determining the battery status input is greater than the uninterruptible power supply, generating the one or more bypass signals to cause the bypass circuit to bypass the boost converter to directly power the uninterruptible power supply; or optionally further comprising:
receiving a switch status for each switch of two or more operating switches;
upon determining a first switch status and a second switch status are below a predetermined threshold, receiving the battery status input from the external battery cabinet; and
upon determining the first switch status and the second switch status are
greater than the predetermined threshold, receiving an additional switch status for each switch of the two or more operating switches.

## Amended claims

### Amended claims in accordance with Rule 137(2) EPC.

1. A system for powering an uninterruptible power supply comprising:
an external battery cabinet configured to power the uninterruptible power supply, wherein the external battery cabinet operates at a predetermined battery voltage;
a boost pulse-width modulator (PWM) controller including two or more operating switches;
a boost converter coupled to the boost PWM controller, wherein the boost converter is configured to increase the predetermined battery voltage of the external battery cabinet based on signals received from the two or more operating switches;
a bypass circuit configured to bypass the boost converter to allow power to directly flow from the external battery cabinet to the uninterruptible power supply without increasing the predetermined battery voltage of the external battery cabinet;
a voltage sensing circuit configured to measure a voltage of the external battery cabinet and the uninterruptible power supply; and
a microcontroller configured to generate at least one of one or more boost signals or one or more bypass signals to activate at least one of the boost converter or the bypass circuit based on the voltage measured by the voltage sensing circuit of the external battery cabinet and the uninterruptible power supply.

2. The system of claim 1, further comprising:
a driver circuit configured to power an input supply voltage to the boost PWM controller to generate one or more driving pulses for the two or more operating switches.

3. The system of claim 2, wherein the driver circuit comprises a metal oxide semiconductor field-effect transistor.

4. The system of any one of the preceding claims, further comprising:
an auxiliary power supply unit configured to couple to the external battery cabinet to provide a predetermined amount of power to the external battery cabinet.

5. The system of any one of the preceding claims, further comprising:
a direct-current power supply configured to couple to the boost PWM controller to provide direct-current power to the boost PWM controller.

6. The system of any one of the preceding claims, further comprising:
a reverse voltage protection unit coupled to the uninterruptible power supply, wherein the reverse voltage protection unit is configured to regulate power delivered to the uninterruptible power supply and monitor direction of the power to prevent damage to the uninterruptible power supply.

7. The system of any one of the preceding claims, further comprising:
one or more over current protection devices configured to couple to the external battery cabinet, wherein the one or more over current protection devices are configured to protect the system from overcurrent.

8. The system of any one of the preceding claims, wherein the predetermined battery voltage of the external battery cabinet is 36V.

9. The system of claim 8, wherein the uninterruptible power supply operates at one of 48V or 72V; or optionally
wherein the boost converter is configured to increase the predetermined voltage to greater than 48V; or optionally
wherein the uninterruptible power supply operates at 36V, wherein the bypass circuit is configured to cause the external battery cabinet to directly power the uninterruptible power supply and bypass the boost converter.

10. The system of any one of the preceding claims, wherein the predetermined battery voltage of the external battery cabinet is 48V.

11. The system of claim 10, wherein the uninterruptible power supply operates at 72V.

12. The system of claim 10, wherein the boost converter is configured to increase the predetermined voltage to greater than 72V.

13. The system of claim 8, wherein the uninterruptible power supply operates at 48V, wherein the bypass circuit is configured to cause the external battery cabinet to directly power the uninterruptible power supply and bypass the boost converter.

14. A method for powering an uninterruptible power supply comprising:
receiving a battery status input from an external battery cabinet;
receiving a power supply status input from the uninterruptible power supply;
comparing the battery status input and the power supply status input;
upon determining the battery status input is less than the power supply status input, generating one or more boost signals to cause a boost converter to increase a battery voltage of the external battery cabinet to power the uninterruptible power supply; and
upon determining the battery status input is equal to the power supply status input, generating one or more bypass signals to cause a bypass circuit to bypass the boost converter to directly power the uninterruptible power supply.

15. The method of claim 14, further comprising:
monitoring a direction of the power to the uninterruptible power supply to prevent damage to the uninterruptible power supply; or optionally further comprising:
upon determining the battery status input is greater than the power supply status input of the uninterruptible power supply, generating the one or more bypass signals to cause the bypass circuit to bypass the boost converter to directly power the uninterruptible power supply; or optionally further comprising:
receiving a switch status for each switch of two or more operating switches;
upon determining a first switch status and a second switch status are below a predetermined threshold, receiving the battery status input from the external battery cabinet; and
upon determining the first switch status and the second switch status are greater than the predetermined threshold, receiving an additional switch status for each switch of the two or more operating switches.
